Europäisches Patentamt

European Patent Office

Office européen des brevets

(19)

(11) Publication number: **0 222 496**
**B1**

(12) **EUROPEAN PATENT SPECIFICATION**

(45) Date of publication of the patent specification:
20.09.89

(51) Int. Cl.⁴: **C23C 26/00, H05K 3/10**

(21) Application number: 86307623.8

(22) Date of filing: 02.10.86

(54) Method of producing an electrically conductive pattern on a substrate.

(30) Priority: **10.10.85 US 786413**

(43) Date of publication of application:
20.05.87 Bulletin 87/21

(45) Publication of the grant of the patent:
20.09.89 Bulletin 89/38

(84) Designated Contracting States:
DE FR GB IT

(56) References cited:
EP-A- 0 034 817
EP-A- 0 140 585
EP-A- 0 159 443
GB-A- 733 414
GB-A- 2 113 720
US-A- 3 708 387
US-A- 4 516 836

IBM TECHNICAL DISCLOSURE BULLETIN, vol. 15, no. 9, February 1973, page 2855, New York, US; G. KAUS et al.: "Selective metallization of ceramic substrates"
IBM TECHNICAL DISCLOSURE BULLETIN, vol. 19, no. 3, August 1976, page 1014, IBM Corp., New York, US; R.H. BANKS et al.: "Laser generated conductive lines"
IBM TECHNICAL DISCLOSURE BULLETIN, vol. 15, no. 2, July 1972, pages 603,604, New York, US; M. ANSCHEL:

(73) Proprietor: **International Business Machines Corporation, Old Orchard Road, Armonk, N.Y. 10504(US)**

(72) Inventor: **Despax, Bernard Serge Université Paul Sabatier, Lab.de Génie Electrique 118 Route de Narbonne, F-31067 Toulouse Cedex(FR)**
Inventor: **Kay, Eric, 20280 Via Santa Teresa, San Jose California 95120(US)**

(74) Representative: **Moss, Robert Douglas, IBM United Kingdom Limited Intellectual Property Department Hursley Park, Winchester Hampshire SO21 2JN(GB)**

(56) References cited: (continuation)
**"Laser-plating system for printed circuitry"**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention is concerned with a method of producing an electrically conductive pattern on a substrate.

Prior art techniques for producing an electrically conductive pattern on an electronic device or on a substrate between electronic devices have used many processing steps, generally including the application of a metalic layer, subsequent application of a photosensitive film, expposure of the film via a mask, removal of either the exposed or the unexposed portions of the film, etching away of the metallic layer and then removal of the remainder of the photosensitive film. Alternatively, the photosensitive film has been added first, exposed and partly removed, metal has been added and the remainder of the photosensitive film has been removed.

In European Patent Application EP-A 0 159 443 (date of publication 30.10.85) a conductor path is formed by providing an insulating substrate having a surface region which is formed of an insulating composition. The insulating composition contains an organic polymeric material and at least one metal source. The surface region of the substrate is selectively heated along a predetermined pattern thereby decomposing and evaporating the organic polymeric material at the heated portion and welding the metal in the heated portion so as to from a conductor path.

IBM Technical Disclosure Bulletin (Vol 15 no. 9 February 1973 p. 2855) discloses a method of selectively applying conductor paths on to a substrate by a first covering the substrate with a two phase thermoplastic/metal powder, applied by spraying, and then selectively exposing portions of the surface to a laser. The powder is heated in the irradiated areas, whereby the thermoplasatic phase melts embedding the metal particles, and adheres to the substrate. The non-exposed powder is removed and the substrate is fired, volatilizing the remaining thermoplastic material, and causing the metal particles to sinter together.

UK Patent Application GB-A 2 113 720 describes a method for forming metal alloy tracks on a planar substrate. The substrate is coated with solder particles in a fluid carrier. The surface is selectively exposed to a focussed beam of radiant energy of a wavelength such that there is little absorption of energy in the fluid carrier and a high absorption of energy in the particles which are thereby fused to the substrate. The substrate is then washed to remove surplus particles.

In the field of optical imaging, US-A 3 801 314 (Goffe) discloses a method of producing an optical image on a substrate. This involves placing a softenable layer on the substrate and adding opaque particles at the surface of the layer. An electrostatic potential is built up between the particles and the substrate and the particles are then imagewise exposed to light. In the exposed regions the layer softens and the particles at its open surface migrate, under electrostatic attraction, to the substrate. In the unexposed areas the softenable layer is not significantly heated, the layer does not soften and particle migration is negligible.

After migration has occurred, the majority of the softenable layer is removed by a solvent, leaving particles on the substrate surface only in the regions subjected to exposure of light. Thus an optical image is produced corresponding to the radiation pattern to which the softenable layer is exposed.

US-A-4,252,890 (Haas et al) discloses an alternative method of producing an optical image on a substrate. This starts with a transport softenable layer on the substrate, the layer having opaque particles either dispersed throughout it or at its open surface. The softenable layer is imagewise exposed to light and particles in the exposed regions agglomerate to form fewer, larger particles. This results in the material of the particles having a lower cross-sectional area when viewed towards the substrate face than in the unexposed areas, so again an image is formed corresponding to the radiation pattern to which the softenable layer is exposed. In this case, the image is a positive of the exposure pattern, i.e, the exposed areas are more transmissive of light. Also, no electrostatic potential is used and the softenable layer is not removed.

Many of the materials suggested for use as the opaque particles are themselves electrically insulating and conductivity of the films is not discussed.

Thus the prior art techniques have involved many processing steps and material removal in order to produce a conductive pattern.

Accordingly, the present invention provides a method of producing an electrically conductive pattern on a substrate comprising the steps of producing on surface of said substrate a film comprising an electrically insulating polymeric matrix material containing mutually isolated electrically conductive metallic particles so distributed that the film is electrically insulating, said matrix material being chemically non-reactive with the material of said particles, said film being formed by the co-deposition of said matrix material and said conductive particles, said matrix material being deposited by vapour deposition and said conductive particles being deposited by sputtering, and locally heating the insulating film without melting or evaporating said film in a pattern corresponding to the desired electrically conductive pattern, thereby to render the film electrically conductive in the locally heated areas.

Preferably the material of the electrically conductive particles is gold since it has good conductivity and it is chemically inert, so that it remains in the elemental state.

Preferably, the insulating polymeric matrix material contracts on heating; this means that a lower proportion of conductive particulate material by volume can be used in the initial film that would otherwise be the case, so that the non-irradiated areas have a higher resistivity than would otherwise be the case. Preferably this material should be a highly crosslinked and chemically inert polymer, to prevent reaction with the electrically conductive particle clusters. A suitable material is polytetrafluoroethylene (PTFE), which contracts on heating by up to 30%.

Preferably the electrically conductive particles represent approximately 15% by volume of the insulating film prior to irradiation. This provides a reasonable compromise between high initial resistivity and low irradiated resistivity.

Preferably the local heating is produced by a laser. This enables the conductive pattern to be achieved quickly and without the use of optical masks.

Preferably the initial film thickness is approximately 1500Å and the electrically conductive particles are arranged in clusters between 25 and 150Å across.

Figure 1 is a graph of resultant resistivity versus applied laser power; and

Figure 2 is a graph of resultant resistivity versus maximum temperature reached for two different initial gold proportions as a percentage of the total film volume.

According to the present invention, an electrically conductive circuit is written on a substrate by a totally non-chemical process comprising the steps of covering the substrate with a very thin film of a medium consisting of electrically isolated conducting clusters of particles in an insulating matrix material, irradiating selective portion of the medium with a laser and thereby causing migration of the conducting cluster and agglomeration of said clusters into conductive areas defined by the laser irradiation.

The substrate is first covered with a layer of insulating matrix material having dispersed therein electrically isolated conducting clusters of particles. The layer is very thin, typically about 1500Å thick (10Å = 1nm). The dispersed clusters of particles are from about 25 to 150 Å in size. It is an essential feature of the present invention that the conducting clusters and the insulating matrix material be chemically non-reactive with each other to assure bulk conductivity in the final conducting pattern.

In carrying out the process of the present invention, selective portions of the medium are irradiated with a laser. The laser causes thermally activated physical structure changes in the film media but causes no chemical reaction whatsoever. The final film is just as chemically stable after irradiation as it was before.

In order to prepare films less than 10000 Å in thickness and control dispersion uniformity as a function of thickness, the deposition should take place by vapour deposition. One preferred process in carrying out such a vapour deposition while simultaneously including dispersed metal particles is shown in US-A-4,226,896.

As mentioned above, the preferred embodiment of the present invention is gold particles dispersed in polytetrafluoroethylene which is highly crosslinked. In various other imaging systems in the prior art, a laser has been used to melt a matrix and the granules so that granules can diffuse. This is in very sharp contrast to the present invention in which gold moves in the polytetrafluoroethylene matrix at a temperature of only 160°C, at which temperature the polytetrafluoroethylene undergoes a glass to rubber transition. This temperature of 160°C is much lower than that of prior art migration systems involving melting. Because the temperature is so much lower, much less power is required, and this represents a very important advantage in the context of low temperature processing.

It should also be emphasised that the present process involves a system which comprises a single layer and requires only a one-step deposition process. Prior art processes typically require multiple deposition steps.

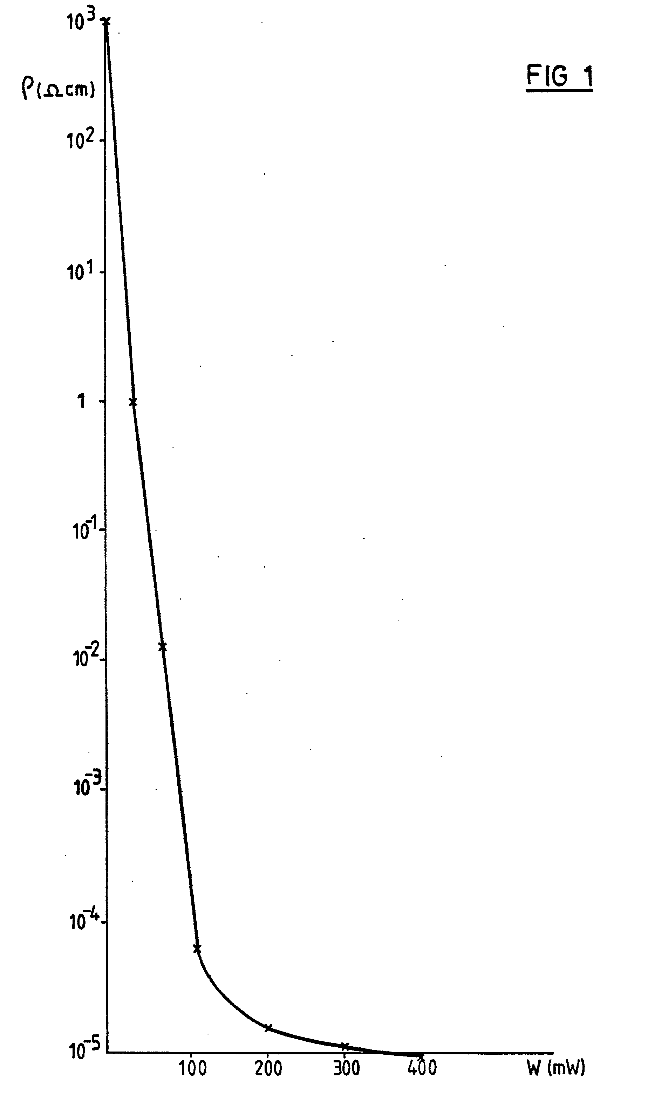

Following the laser irradiation and agglomeration of the conductive particles a conducting image is formed having a conductivity eight orders of magnitude greater than that of the non-irradiated layer. The conductivity of the resultant gold is that of bulk gold. Figure 1 shows how the resulting resistivity varies with applied laser power for a fixed laser spot size and fixed initial volume ratio of gold to polymer. The large change in resistivity mentioned can clearly be seen.

The process of the present invention provides a very economical way to deposit select lines with adequately controlled stable electrical and mechanical properties. The process is suitable for multilevel fine line chip circuitry devices. The dry process of the present invention eliminates many processing steps currently employed in wet procedures. It thereby greatly reduces costs and results in high yield at a lower capital investment. Most importantly, the ability to repair circuits using laser beam addressed processing is achieved.

A preferred way to form the films of the present invention is to use a conventional radio frequency (r.f.) capacitively coupled diode sputtering system in which the powered electrode surface consists of gold while the substrate, for example, quartz, sapphire or poly(methylmethacrylate) (PMMA), is in good thermal contact with the temperature controlled grounded coplanar anode electrode.

The plasma gas mixture is chosen so that the appropriate amount of gold is continously sputtered off the powered electrode while at the same time polymer film is produced uniformly on the substrate into which the sputtered gold particles are trapped during film growth.

This condition is met by picking the appropriate flurocarbon monomer together with an appropriate inert sputtering gas so that polymerisation dominates at the anode while at the same time metal sputtering dominates at the powered electrode. Polymerisation on the gold electrode must be avoided.

Since the ratio of gold to polymer in the final recording medium has to be within a certain range and since the film has to have a uniform dispersion of the metal clusters as a function of thickness, only special polymer forming gases mixed with the appropriate sputtering gases can be used.

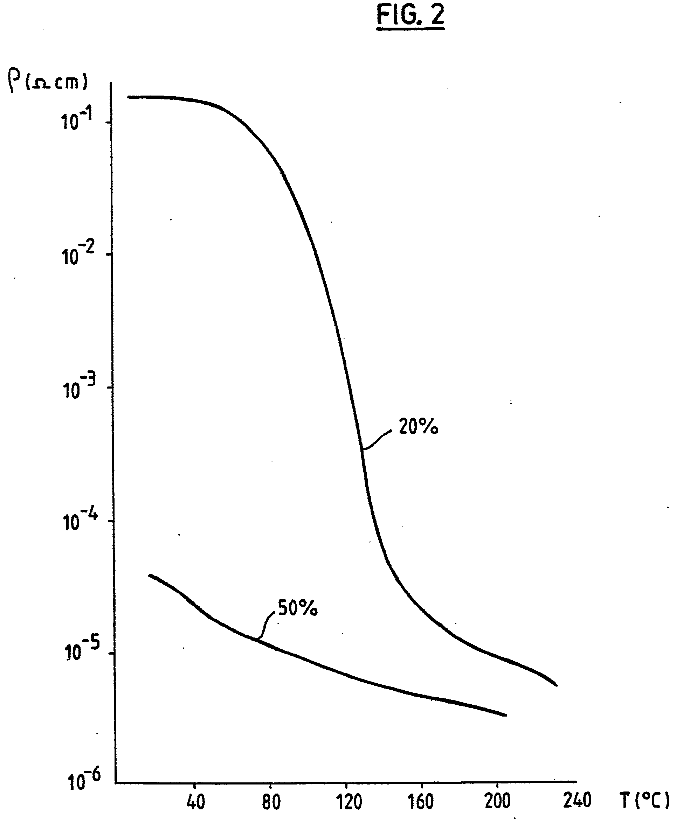

Figure 2 shows the effect of varying the metal/polymer ratio. It can be seen that at 20% initial gold proportion, the initial resistivity is about $2 \times 10^{-1}$ Ohm cm; this is in comparison to $10^3$ Ohm cm at 15% initial gold proportion. At 50% initial gold proportion the initial resistivity is reduced still further to about $5 \times 10^{-5}$ Ohm cm. Similarly the final resistivity (after irradiation) also decreases with increasing gold proportion.

Specific Example

Specifically, to obtain the right metal volume ratio and cluster size, the following conditions are used. A mixture of $C_3F_8/Ar$ in the ratio 1 to 50 is injected into the diode system at a flow rate of 10 -20 standard cubic centimetres per minute at total gas pressure from 20 to 30 mTorr (2.7 to 4 Pascals) The r.f. discharge is run at 50 watts. The substrate temperature is maintained below 30°C in order to obtain the desired reproducible metal/volume fraction and cluster size from run to run.

The resultant recording medium consists of a highly uniform dispersion of small gold clusters in a highly crosslinked fluorocarbon plasma-polymerised matrix. The films consist of stable ingredients which have excellent archival characteristics. The films are pinhole free and uniform. The films adhere well to a number of different substrates.

The laser used was an unfocussed $Kr^+$ laser at a wavelength of about 647 nm adjusted to deliver at least $2 \times 10^4$ watts/cm$^2$ to the film surface. Laser irradiation produced a material which changed its electrical resistivity by eight orders of magnitude, from $10^3 \, \Omega$ cm to $9 \times 10^{-6} \, \Omega$ cm.

The time to expose a $40\mu \times 40\mu$ spot was 0.5 sec. It should be noted that the process was carried out in air, unlike many prior art procedures which must be carried out in vacuum.

**Claims**

1. A method of producing an electrically conductive pattern on a substrate comprising the steps of: producing on a surface of said substrate a film comprising an electrically insulating polymeric matrix material containing mutually isolated electrically conductive metallic particles so distributed that the film is electrically insulating, said matrix material being chemically non-reactive with the material of said particles, said film being formed by the co-deposition of said matrix material and said conductive particles, said matrix material being deposited by vapour deposition and said conductive particles being deposited by sputtering, and

locally heating the insulating film, without melting or evaporating said film, in a pattern corresponding to the desired eletrically conductive pattern, thereby to render the film electrically conductive in the locally heated areas.

2. A method as claimed in claim 1, in which the material of said particles is gold.

3. A method as claimed in any preceding claim in which the particles represent approximately 15% by volume of the insulating film prior to irradiation.

4. A method as claimed in any preceding claim in which the particles are arranged in clusters, each cluster being between 25 and 150 Å across.

5. A method as claimed in any preceding claim in which the insulating matrix material contracts on heating.

6. A method as claimed in any preceding claim, in which the insulating matrix material is a highly crosslinked polymer.

7. A method as claimed in any preceding claim in which the insulating matrix material is a polytetrafluoroethylene.

8. A method as claimed in any preceding claim in which the thickness of the insulating film prior to irradiation is approximately 1500 Å.

9. A method as claimed in any preceding claim, in which the local heating is produced by a laser.

**Patentansprüche**

1. Verfahren zur Herstellung eines elektrisch leitfähigen Musters auf einem Substrat, welches als Schritte beinhaltet: auf einer Oberfläche des Substrates wird eine Schicht hergestellt, die aus einem elektrisch isolierenden polymeren Trägermaterial besteht, wobei in dem Trägermaterial voneinander wechselseitig isolierte elektrisch leitfähige Metallteilchen so verteilt enthalten sind, daß die Schicht elektrisch isolierend ist, das Trägermaterial mit dem Material der Teilchen chemisch nicht reaktionsfähig ist, wobei die Schicht durch das gemeinsame Aufbringen des Trägermaterials und der leitfähigen Teilchen gebildet wird, das Trägermaterial durch Aufdampfen und die leitfähigen Teilchen durch Sputtern aufgebracht werden, und die isolierende Schicht wird lokal ohne die Schicht zu schmelzen oder zu verdampfen in einem Muster erwärmt, das dem gewünschten elektrisch leitfähigen Muster entspricht, um dadurch die Schicht in den lokal erwärmten Bereichen elektrisch leitfähig werden zu lassen.

2. Verfahren nach Anspruch 1, bei welchem das Material der Teilchen Gold ist.

3. Verfahren nach irgendeinem der vorhergehenden Ansprüche, bei welchem die Teilchen vor der Bestrahlung etwa 15% Volumsanteil der isolierenden Schicht ausmachen.

4. Verfahren nach irgendeinem der vorhergehenden Ansprüche, bei welchem die Teilchen in Clustern angeordnet sind, wobei jeder Cluster eine Querschnittsabmessung zwischen 25 und 150 Å aufweist.

5. Verfahren nach irgendeinem der vorhergehenden Ansprüche, bei welchem das isolierende Trägermaterial sich beim Erwärmen zusammenzieht.

6. Verfahren nach irgendeinem der vorhergehenden Ansprüche, bei welchem das isolierende Trägermaterial ein hochvernetztes Polymer ist.

7. Verfahren nach irgendeinem der vorhergehenden Ansprüche, bei welchem das isolierende Trägermaterial ein Polytetrafluoräthylen ist.

8. Verfahren nach irgendeinem der vorhergehenden Ansprüche, bei welchem die Dicke der isolierenden Schicht vor der Bestrahlung etwa 1500 Å beträgt.

9. Verfahren nach irgendeinem der vorhergehenden Ansprüche, bei welchem die lokale Erwärmung durch einen Laser erzeugt wird.

## Revendications

1. Procédé de fabrication d'une configuration électriquement conductrice sur un substrat, qui comprend les opérations de: préparation, sur une surface dudit substrat, d'un film composé d'une matière de matrice de type polymère électriquement isolante contenant des particules métalliques électriquement conductrices mutuellement isolées, réparties de sorte que le film est électriquement isolant, ladite matière de matrice étant chimiquement non réactive avec la matière desdites particules, ledit film étant formé par le co-dépôt de ladite matière de matrice et desdites particules conductrices, ladite matière de matrice étant déposée par dépôt en phase vapeur et les dites particules conductrices étant déposées par projection, et

chauffage local du film isolant, sans fondre ou évaporer ledit film, suivant une configuration correspondant à la configuration électriquement conductrice désirée, de manière à rendre le film électriquement conducteur dans les zones localement chauffées.

2. Procédé suivant la revendications 1, dans lequel la matière des dites particules est de l'or.

3. Procédé suivant l'une quelconque des revendications précédentes, dans lequel les particules représentent environ 15% en volume du film isolant avant irradiation.

4. Procédé suivant l'une quelconque des revendications précédentes, dans lequel les particules sont disposées en amas, chaque amas ayant une dimension comprise entre 2,5 et 15 nm.

5. Procédé suivant l'une quelconque des revendications précédentes, dans lequel la matière de matrice isolante se contracte lors du chauffage.

6. Procédé suivant l'une quelconque des revendications précédentes, dans lequel la matière de matrice isolante est un polymère fortement réticulé.

7. Procédé suivant l'une quelconque des revendications précédentes, dans lequel la matière de matrice isolante est un polytétrafluoroéthylène.

8. Procédé suivant l'une quelconque des revendications précédentes, dans lequel l'épaisseur du film isolant avant irradiation est de 150 nm environ.

9. Procédé suivant l'une quelconque des revendications précédentes, dans lelquel le chauffage local est produit par un laser.

EP 0 222 496 B1

$\rho\,(\Omega\,cm)$

FIG 1

W (mW)

FIG. 2